# EUROPEAN PATENT SPECIFICATION

(11) **EP 0 470 303 B1**
(45) Date of publication and mention of the grant of the patent: **05.01.1994**
(21) Application number: 90304843.7
(22) Date of filing: 03.05.1990
(51) Int. Cl.: G01R 31/26, G01R 31/28, G01R 31/30

(54) **Test chambers**
Testkammern
Chambres d'essai

(43) Date of publication of application: 12.02.1992
(73) Proprietor: Venturedyne Ltd, West Allis, Wisconsin 53227 (US)
(72) Inventor: Liken, Peter A., West Olive, Michigan 49460 (US); Hartwig, Kevin L., Holland, Michigan 49423 (US); Martin, Peter A., Holland, Michigan 49423 (US)
(74) Representative: Knott, Stephen Gilbert

(56) References cited:
- EP-A- 0 181 729
- US-A- 4 542 341
- US-A- 4 713 611
- ELEKTRONIK. vol. 36, no. 24, November 1987, MUNCHEN DE pages 113 - 116; G.Ost: "Zuverlässigkeitssicherung mit Burn-In-Systemen"

## Description

This invention relates to environmental test chambers and, more particularly, to product carriers for use in such chambers.

A common application for environmental test chambers is to carry on tests on various electronic devices, for example "burn-in" of circuit boards. In such tests, circuit boards or electronic devices (products) are placed in an environmental chamber and cycled through their operational sequences while simultaneously being subjected to varying conditions of temperature, humidity and often shock and/or vibration. These types of product testing and evaluation are common and well known.

One of the problems encountered in connection with these types of chambers is in the transport of the product to the chamber and the connection and set up of the product in the chamber for testing, and changing the test cycle to accommodate different products or different test cycles for the same product. Various arrangements have been proposed for accomplishing the functions of moving product into and out of the test chamber, and for connecting the product electrically and supporting the product physically in the test chamber during testing. An example of one such prior proposal can be found in U.S. Patent 4,683,424, which is assigned to the assignee of this application.

This invention is similarly concerned with these problems of product transport, connection and set up for testing and has among its general objects to provide an improved product carrier which facilitates those operations in the test chamber.

A more specific object is to reduce the exposure of the environment within the test chamber to the electrical connections necessary for product testing, i.e., exposure to the varying temperature and/or humidity within the chamber.

Another specific object of this invention is to provide ready access to the product's external electrical connections for repair, maintenance, or, if necessary, changes to vary a test cycle.

For the achievement of these and other objects, this invention proposes a product carrier and test chamber construction comprising the Features disclosed in claim 1, whereby the product carrier has an extended external terminal port through which the external test circuit connections are made and the combination of that product carrier with a test chamber configured to accommodate the extended port so that the connections to the external test circuit are removed from the test chamber environment. The product carrier includes a support structure which physically orients the product in the chamber and includes an electrical junction arrangement through which the product can be connected to a test circuit. The electrical junction, or junctions, when positioned within the test chamber are connected to an external test circuit which controls the cycling of the product through a preselected test procedure. The electrical circuitry for making the electrical connection to the external connector is incorporated in the product carrier. More specifically, the product carrier is provided with a terminal port which is supported on one of the walls of the carrier. The carrier and test chamber are constructed and arranged such that the carrier is inserted into the chamber by sliding it into the chamber. The leading wall of the carrier is provided with a projecting port, i.e., an extended port, that, as the carrier is moved into its intended position within the chamber, mates with a junction to an external circuit. Because the port extends from the carrier wall, the external junction is not located within the chamber itself, but is physically isolated from it. With this arrangement, the circuit elements running from the individual products are channeled to and through the extended port. This then positions the wiring ends for the individual products in an area which is readily accessible from the exterior of the test chamber. Access can be made to that wiring through the external chamber wall which carries the external junction.

One embodiment of the invention will now be described, by way of example only, with reference to the accompanying drawings in which:
Fig. 1 is a perspective view of a test chamber illustrating several product carriers inserted in a test chamber;
Fig. 2 is a generally schematic illustration of a typical product, in this case a circuit board;
Fig. 3 is a perspective view of a product carrier having one circuit board assembled in the carrier and showing a portion of an external wall of the chamber having an external electrical plug assembly; and
Fig. 4 is a side elevation of a product carrier partially inserted in a test chamber, both carrier and test chamber constructed in accordance with this invention.

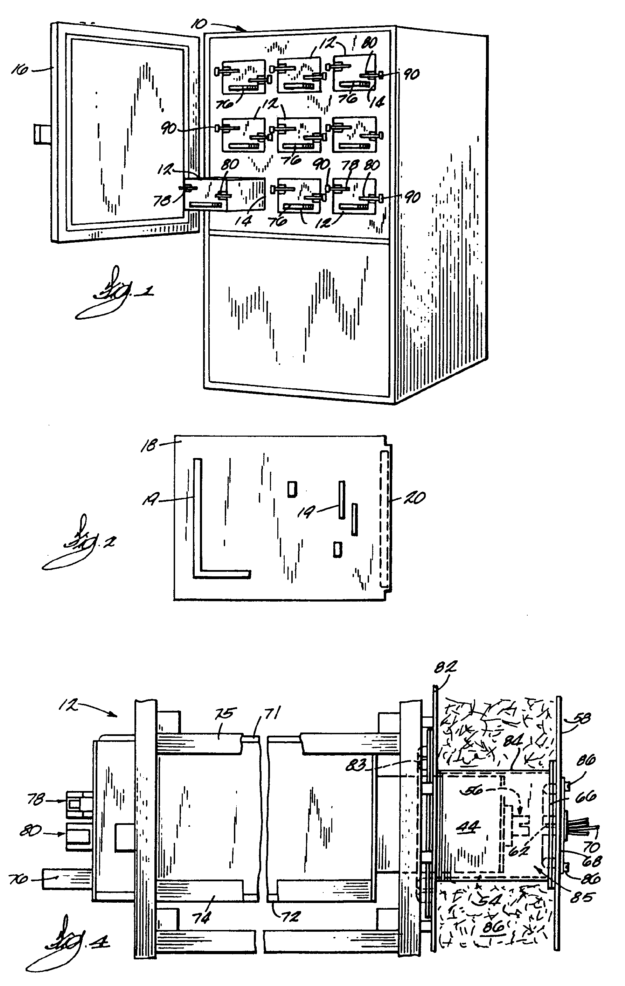

With particular reference to Fig. 1 of the drawing, a test chamber 10 is illustrated as having a plurality of product carriers 12 inserted therein. One such carrier is shown partially withdrawn from the test chamber to illustrate the fact that the carriers are inserted in the test chamber by sliding them through the opening 14. The test chamber can be provided with an outer door 16 to close and secure the interior of the test chamber after the desired product carriers, and product, have been inserted in the chamber.

The test chamber is usually provided with heating, cooling, and/or humidifying mechanisms, and in some instances vibration creating mechanisms. These can be housed in the lower portion of the test chamber, i.e., below opening 14, or in some cases, and with certain mechanisms, external to the chamber. These are conventional, so they have not been illustrated. Similarly, controls for these mechanicals are usually provided and located external to the chamber. Since the controls too are conventional, they have not been illustrated.

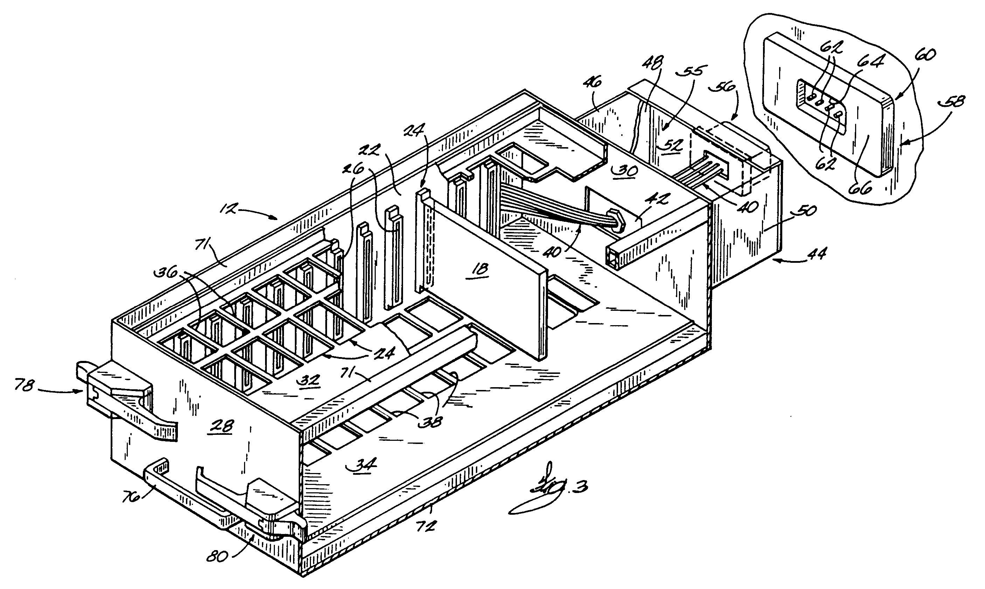

Fig. 2 illustrates a typical product of the type which can be tested in the chamber. In this case, it is an electrical circuit board 18 having conventional circuit elements 19 thereon and an electrical plug 20. The product could as well be any one of a number of electrical components or actual assembled devices such as radios, cellular telephones, electrical instruments or the like.

With reference to Fig. 3, one of the product carriers 12 is illustrated. The product carrier includes a mother board 22 forming a wall extending along one side of carrier. The mother board is provided with a plurality of electrical junctions 24 and each junction includes a female plug 26 for receipt of plug 20 of the circuit boards. For convenience, only one circuit board is illustrated in Fig. 3 so that the interior of the carrier is more visible. In practice, a circuit board 18 would be associated with each of the junctions 24.

To complete the physical structure of the carrier, it includes front and rear panels 28 and 30 and top and bottom panels 32 and 34. The front and rear panels are closed while the top and bottom panels include a plurality of openings 36 in the top and 38 in the bottom for ventilation purposes.

The wires from the junctions 24 are contained in the mother board and extend from the mother board to end plate 30, see wire bundle 40 in Fig. 3. The wires 40 extend through a plate 42 into an extended port 44. The extended port is made up of top wall 46, sidewalls 48 and 50, end wall 52 and bottom wall 54 (see Fig. 4) which, together with rear panel 30 of the carrier, form a cube shaped chamber 55. The leads 40 extend into and through the chamber 55. Leads 40 terminate in an electrical junction 56 which projects laterally from wall 52 of the extended port.

A portion 58 of the outer wall of the test chamber 10 is illustrated in Fig. 3. That portion of the outer wall carries an electrical plug assembly 60 configured to mate with the junction 56. Electrical plug 60 consists of conventional electrical terminals 62 located in an opening 64 in rectangular block 66. As can perhaps best be seen in Fig. 4, the rectangular block 66 is connected to a plate 68 which in turn is suitably releasably fastened to the outer chamber wall 58. Electrical connections are made to the terminals 64 through suitable wire connectors, see wire bundle 70 in Fig. 4. Wire bundle 70 provides the incoming circuitry for the test circuit.

With references to Figs. 3 and 4, the product carrier 12 includes upper slides 71 and 72, one in each of the lower corners of the carrier, only one being visible in Fig. 3 and in Fig. 4. These slides engage an upper pair of horizontally spaced brackets 74 and a lower pair of horizontally spaced brackets 75 within the test chamber, only one bracket on one side of the product carrier in each pair can be seen in Fig. 4, a similar bracket (not shown) is provided on the opposite side..

The above construction attributes a quadrilateral box configuration to the product carrier. The product carrier is positioned with the slides 71 and 72 engaged with brackets 74 and 75. Once so engaged, the product carrier, with the circuit boards assembled therein, slides into the test chamber along the brackets. The brackets 74 and 75 and the slides 71 and 72 relative to junction 56 are positioned such that the junction 56 is aligned with opening 64 and terminals 62. The extended port 44 is positioned on the leading wall 30 of the carrier, that is the leading wall relative to carrier movement into the chamber. With this construction and arrangement, the product carrier, as it is moved into place in the test chamber, moves the junction 56 into electrical engagement with terminals 64. That completes the electrical connection to a suitable test control circuit (connected to wire bundle 70 but not shown) to the mother board and through the mother board to the circuit boards 18.

To facilitate movement of the product carrier into and out of the test chamber, a suitable handle 76 is provided on the front wall 28. Over center latches 78 and 80 are provided on that front wall. The latches cooperate with suitable latch bales 90 on the test chamber walls to securely seat and lock the product carrier in place after the electrical connection has been made between junction 56 and terminals 62.

Referring now specifically to Fig. 4, it will be seen that with the extended port 44 being provided on the leading wall 30 of the product carrier the actual terminal connections to the external terminals 62 are positioned outside of the interior of the test chamber and, therefore, isolated from the conditions which exist within the test chamber. As can be seen in Fig. 4, the outer wall 58 of the test chamber is spaced from the inner wall 82 of the test chamber and a duct 84, rectangular in cross-section, is formed which extends between outer wall 58 and inner wall 82. Duct 84 defines a cube shaped space 85 to receive and accommodate the extended port 44. Gasket rings 83 are arranged between inner wall 82 and the rear panel 30 of the carrier. As the carrier is seated in place in the chamber, gasket rings 83 are compressed between wall 82 and panel 30. This provides a secure seal and prevents any entry of the chamber environment into the extended port. Suitable insulation 86 is included in the space between walls 58 and 82 and around duct 84 in a conventional manner.

Plate 66 is releasably attached to end wall 58 by fasteners 86. With this arrangement, the plate 66 can be removed from the wall 58 to gain access to both the electrical junction 56 and plug 64 without having to remove the product carrier from the test chamber or without major disruption of the environment which has been created within the test chamber. Maintenance and repair can then be conducted on the electrical junction 56 and plug 64 or, if necessary, wiring can be changed to provide for a different test mode.

It should also be noted that with this arrangement, the external connections, junction 56 and terminals 62 are removed from the interior of the test chamber and are therefore basically isolated from the environmental changes which occur within the test chamber. Therefore, the external electrical terminal is not affected by those environmental changes.

Although but one embodiment of the present invention has been illustrated and described, it will be apparent to those skilled in the art that various changes and modifications may be made therein without departing from the scope of the appended claims.

## Claims

1. A product carrier and test chamber construction comprising, in combination,
a product carrier (12) having a framework made up of a plurality of walls,
one of said walls (22) including means defining a plurality of junctions (24) for electrical connection to products positioned in said product carrier (12),
means defining supports within said test chamber (10) for receipt of said carrier (12) and for guiding said carrier into the test chamber and towards an outer wall (58) of said test chamber,
junction means (62) on said outer wall (58) and aligned with said supports,
said carrier having a wall which is leading wall (30) in reference to movement of said product carrier into said test chamber (10), said combination being characterised by comprising
means defining an extension projecting from said leading wall (30) and having an electrical junction (56) spaced from said leading wall,
said electrical junction (56) on said leading wall, when said product carrier is engaged with said supports, being aligned with said junction means (62) on said outer wall, and
electrical leads (40) connected to said electrical junctions (24) on said one wall (22) and extending therefrom through said leading wall (30) to said extension and through said extension to said electrical junction (56) on said extension,
so that an external connection is made to products carried by said product carrier through said junction (62) on said outer test chamber wall (58).

2. The The product carrier and test chamber construction of Claim 1 wherein said product carrier (12) has a generally trapezoidal cube shape, and
said extension has a generally cube shape formed by a plurality of side walls (46,48,50,54) and end walls (52,30), one end wall being said leading wall (30).

3. The The product carrier and test chamber construction of Claim 2 wherein said outer wall (58) includes a plate (68) and said junction means (62) on said outer wall (58) is attached to said plate, and including means releasably attaching said plate to said outer wall.

## Patentansprüche

1. Erzeugnisträger und Prüfkammeraufbau, der in Kombination umfaßt:
einen Erzeugnisträger (12) mit einem Rahmen, der aus einer Vielzahl von Wänden besteht,
wobei eine der Wände (22) eine Einrichtung enthält, die eine Vielzahl von Anschlüssen (24) zur elektrischen Verbindung mit in dem Erzeugnisträger (12) befindlichen Erzeugnissen bildet,
Einrichtungen, die Halterungen innerhalb der Prüfkammer (10) zur Aufnahme des Trägers (12) und zur Führung des Trägers in die Prüfkammer hinein und in Richtung einer äußeren Wand (58) der Prüfkammer bilden,
Anschlußeinrichtungen (62) an der äußeren Wand (58), die mit den Halterungen fluchtend sind,
wobei der Träger eine Wand hat, die in bezug auf die Bewegung des Erzeugnisträgers in die Prüfkammer (10) eine vordere Wand (30) darstellt, wobei die Kombination **dadurch** **gekennzeichnet** ist, daß die umfaßt:
eine Einrichtung, die eine Verlängerung bildet, die von der vorderen Wand (30) vorsteht und einen elektrischen Anschluß (56) aufweist, der von der vorderen Wand beabstandet ist,
wobei der elektrische Anschluß (56) an der vorderen Wand mit den Anschlußeinrichtungen (62) an der äußeren Wand fluchtend ist, wenn der Erzeugnisträger mit den Halterungen im Eingriff ist, und
elektrische Leitungen (40), die mit den elektrischen Anschlüssen (24) an der einen Wand (22) verbunden sind und von selbigen durch die vordere Wand (30) zu der Verlängerung und durch die Verlängerung zu dem elektrischen Anschluß (56) an der Verlängerung verlaufen,
so daß über den Anschluß (62) an der äußeren Prüfkammerwand (58) eine externe Verbindung mit Erzeugnissen hergestellt wird, die von dem Erzeugnisträger getragen werden.

2. Erzeugnisträger und Prüfkammerkonstruktion nach Anspruch 1, wobei der Erzeugnisträger (12) eine im allgemeinen viereckige würfelform aufweist, und
die Verlängerung eine im allgemeinen würfelartige Form hat, die durch eine Vielzahl von Seitenwänden (46, 48, 50, 54) und Abschlußwände (52, 30) gebildet wird, wobei eine Abschlußwand die vordere Wand (30) ist.

3. Erzeugnisträger und Prüfkammerkonstruktion nach Anspruch 2, wobei die äußere Wand (58) eine Platte (68) enthält, und die Anschlußeinrichtung (62) an der äußeren Wand (58) an der Platte angebracht ist und Mittel enthält, die die Platte lösbar an der äußeren Wand halten.

## Revendications

1. Construction à transporteur de produits et chambre d'essai comprenant, combinés,
un transporteur de produits (12) ayant une structure composée d'une pluralité de parois,
une desdites parois (22) comportant un moyen définissant une pluralite de jonctions (24) pour la connexion électrique aux produits placés dans ledit transporteur de produits (12),
un moyen définissant des supports au sein de ladite chambre d'essais (10) pour la réception dudit transporteur (12) et pour guider ledit transporteur dans la chambre d'essais et vers une paroi externe (58) de ladite chambre d'essais,
un moyen de jonction (62) sur ladite paroi externe (58) et aligné avec lesdits supports,
ledit transporteur ayant une paroi qui est une paroi de tête (30) par rapport au déplacement dudit transporteur de produits à l'intérieur de ladite chambre d'essais (10), ladite combinaison étant caractérisée par le fait qu'elle comprend
un moyen définissant une extension dépassant de ladite paroi de tête (30) et ayant une jonction électrique (56) espacée de ladite paroi de tête,
ladite jonction électrique (56) sur ladite paroi de tête, lorsque ledit transporteur de produits est engagé avec lesdits supports, alignée avec ledit moyen de jonction (62) sur ladite paroi externe, et
des câbles électriques (40) connectés auxdites jonctions électriques (24) sur ladite paroi (22) et partant de ces jonctions à travers ladite paroi de tête (30) jusqu'à ladite extension et à travers ladite extension vers ladite jonction électrique (56) sur ladite extension,
de sorte qu'une connexion externe est faite avec les produits transportés par ce transporteur de produits par l'intermédiaire de ladite jonction (62) sur ladite paroi externe (58) de la chambre d'essais.

2. Construction à transporteur de produits et chambre d'essais selon la revendication 1 dans laquelle ledit transporteur de produits (12) a une forme générale de cube trapézoïdal, et
ladite extension a une forme générale de cube formée par une pluralité de parois latérales (46, 48, 50, 54) et de parois d'extrémité (52, 30), une paroi d'extrémité étant ladite paroi de tête (30).

3. Construction à transporteur de produits et chambre d'essais selon la revendication 2 dans laquelle ladite paroi externe (58) comprend une plaque (68) et ledit moyen de jonction (62) sur ladite paroi externe (58) est attaché à ladite plaque, et comportant un moyen fixant de manière détachable ladite plaque à ladite paroi externe.
